# EUROPEAN PATENT APPLICATION

(11) **EP 4 776 832 A1**
(43) Date of publication of application: **15.07.2026**
(21) Application number: 26151387.3
(22) Date of filing: 12.01.2026
(51) Int. Cl.: H10W 20/43, H10W 20/41, H10W 20/40, H10D 1/68, H10W 42/60, H10W 42/80

(54) **TILING EXCLUSION ZONES IN A DEVICE**

(30) Priority: 14.01.2025 US 202519020258
(71) Applicant: NXP B.V., 5656 AG Eindhoven (NL)
(72) Inventor: Sque, Stephen John, 5656AG Eindhoven (NL); Bruggers, Herman Jan, 5656AG Eindhoven (NL); Duan, Ning, 5656AG Eindhoven (NL)
(74) Representative: Krott, Michel

(57) **Abstract**

One example discloses A device, including: a conductive element having a first radius of curvature and a second radius of curvature; a set of tiling elements; wherein the tiling elements are located within a predetermined distance from the first radius of curvature of the conductive element; wherein the tiling elements are located beyond the predetermined distance from the second radius of curvature of the conductive element; and wherein the first radius of curvature is different from the second radius of curvature.

## Description

The present specification relates to systems, methods, apparatuses, devices, articles of manufacture and instructions for tiling exclusion zones, for example in a semiconductor or other process technology.

### SUMMARY

According to an example embodiment, a device, comprising: a conductive element having a first radius of curvature and a second radius of curvature; a set of tiling elements; wherein the tiling elements are located within a predetermined distance from the first radius of curvature of the conductive element; wherein the tiling elements are located beyond the predetermined distance from the second radius of curvature of the conductive element; and wherein the first radius of curvature is different from the second radius of curvature.

In another example embodiment, the first radius of curvature is greater than the second radius of curvature.

In another example embodiment, the first radius of curvature substantially defines a straight line; and the second radius of curvature substantially defines a corner.

In another example embodiment, the second radius of curvature results in a greater electromagnetic field strength than the first radius of curvature when the conductive element is at an electrostatic potential substantially different to that of its surroundings.

In another example embodiment, the first radius of curvature is a first non-zero radius of curvature and the second radius of curvature is a second non-zero radius of curvature.

In another example embodiment, the predetermined distance is configured to define a tiling exclusion zone.

In another example embodiment, the predetermined distance is a first predetermined distance; the tiling elements are located only beyond the first predetermined distance from the first radius of curvature of the conductive element; and the tiling elements are located only beyond a second predetermined distance from the second radius of curvature of the conductive element.

In another example embodiment, the second predetermined distance is greater than the first predetermined distance.

In another example embodiment, a first tiling exclusion zone is formed within the first predetermined distance; and a second tiling exclusion zone is formed within the second predetermined distance.

In another example embodiment, the tiling elements are electrically isolated from the conductive element.

In another example embodiment, a size and relative separation of the set of tiling elements is determined by a semiconductor fabrication design rule specifying a minimum metal density.

In another example embodiment, a subset of the tiling elements are located underneath the conductive element.

In another example embodiment, a subset of the tiling elements are located above the conductive element.

In another example embodiment, the conductive element is a capacitor plate or a circuit trace.

In another example embodiment, the tiling elements are arranged to increase a dielectric-breakdown voltage of the conductive element.

In another example embodiment, the conductive element is a first conductive element; further comprising a second conductive element; wherein the tiling elements are located only beyond the predetermined distance from a crossing of the first conductive element and the second conductive element.

In another example embodiment, the first conductive element is within a first x-y plane, and the second conductive element is within a second x-y plane; and the first x-y plane is parallel to the second x-y plane and the planes are separated by a z distance.

In another example embodiment, the predetermined distance is a first predetermined distance; the tiling elements are within multiple metal layers; the conductive element is within a first x-y layer; a first sub-set of tiling elements within the first x-y layer are only beyond the first predetermined distance from the conductive element in the first x-y layer; and a second sub-set of tiling elements within a second x-y layer are only beyond a second predetermined distance from the conductive element in the first x-y layer.

In another example embodiment, a third sub-set of tiling elements within a third x-y layer are only beyond a third predetermined distance from the conductive element in the first x-y layer.

In another example embodiment, the tiling elements are within multiple metal layers; the tiling elements in the multiple metal layers are all located only beyond the predetermined distance from the second radius of curvature of the conductive element; and the set of metal layers are substantially parallel.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents a first example of metal tiles in a device.
Figure 2 represents a second example of metal tiles in a device.
Figure 3 represents a third example of metal tiles in a device.
Figure 4 represents additional examples of metal tiles in a device.
Figure 5 represents further examples of metal tiles in a device.
Figure 6 represents an example of tiered sets of metal tiles in a device.
Figure 7 represents a fourth example of metal tiles in a device.
Figure 8 represents additional examples of metal tiles in a device.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

High-voltage structures are used in an increasing number of circuit applications. For example, high-voltage capacitors can be used in products in which galvanic isolation is required - i.e., in products in which there are two parts that are at very different voltage levels, but which need to communicate with each other by sending electric signals: the (high-voltage) capacitors block the large DC voltage but allow AC signals to pass through for communication. Such applications include gate drivers and on-board charging (OBC) systems for electric vehicles.

Similarly, high-voltage conductors (e.g. metal traces for circuitry) are used for routing in many high-power applications.

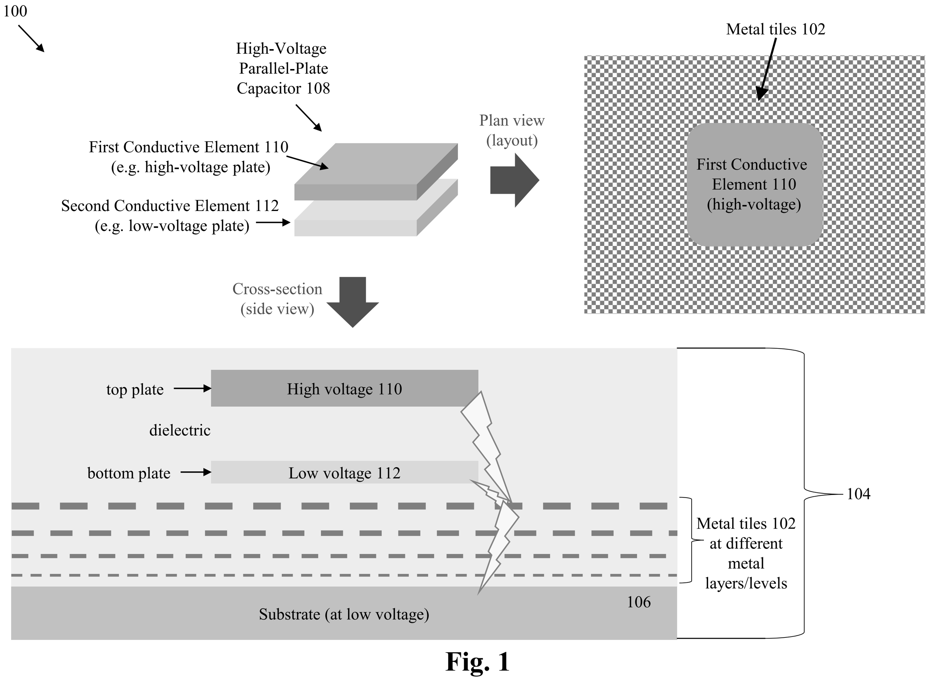

Figure 1 represents a first example 100 of metal tiles 102 in a device 104. The device 104 includes a substrate 106. The first example 100 includes a high-voltage parallel-plate capacitor 108. The capacitor 108 includes a first conductive element 110 (e.g. high-voltage plate) and a second conductive element 112 (e.g. low-voltage plate).

In many process technologies, for example, it is necessary to have metal tiles 102 (a.k.a. dummy tiles or dummies) present in backend metal layers of the device 104 in order to achieve certain minimum metal densities and thereby prevent device 104 fabrication processing issues, such as those related to planarization and polishing.

Metal tiles are herein defined as substantially planar isolated metal elements that are often laid out in an array. Their substantially two-dimensional shape are square and they are separated from neighbor metal tiles by a distance often on the order of their length. Isolated is herein defined as, not connected to other conductors (e.g. circuitry) using an electrically conductive material.

These metal tiles however can act as stepping-stones for dielectric breakdown between high-voltage structures (e.g. the first conductive element 110 (e.g. high-voltage plate)) and low-voltage structures (e.g. the second conductive element 112 (e.g. low-voltage plate)). An example of the stepping-stone dielectric breakdown is shown as a dielectric arc (e.g. lightning bolts) from the high-voltage top plate 110 to a metal tile 102 and then as a dielectric arc to the substrate 106.

Such dielectric arcs reduce the device's 104 breakdown voltage and/or Time-Dependent Dielectric Breakdown (TDDB) lifetime. Furthermore, these metal tiles 102 can also increase unwanted (parasitic) capacitances between the capacitor plates 110, 112 and the surrounding/underlying circuitry and the substrate 106 below.

While not shown in Figure 1, metal tiles may also exist at the same levels as the top and bottom capacitor plates 110, 112, at intermediate levels, or above the top plate 110, depending on the process and on the construction of the capacitor 108.

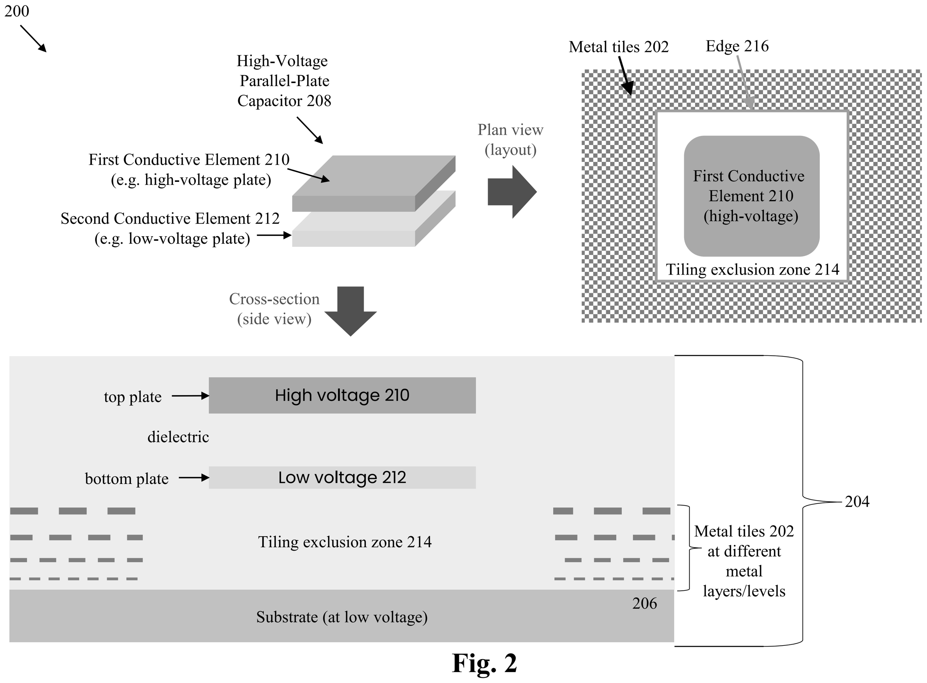

Figure 2 represents a second example 200 of metal tiles 202 in a device 204. The device 204 includes a substrate 206. The second example 200 includes a high-voltage parallel-plate capacitor 208. The capacitor 208 includes a first conductive element 210 (e.g. high-voltage plate) and a second conductive element 212 (e.g. low-voltage plate).

Here shown to reduce a chance of dielectric breakdown between high-voltage structures (e.g. the first conductive element 210 (e.g. high-voltage plate)) and low-voltage structures (e.g. the second conductive element 212 (e.g. low-voltage plate)), and/or the substrate 206, metal tiles 202 can be removed from regions nearby, around and underneath such high-voltage structures. Metal tiles 202 removed from such areas thereby create a tiling exclusion zone 214. A uniform edge 216 of the tiling exclusion zone 214 is also shown.

Such metal tile 202 removal however, can lead to fabrication process design rule violations (e.g. minimum metal density fabrication process design rules).

Now discussed are example embodiments of tiling exclusion zone layouts that can be optimized so as to both minimize and/or eliminate metal tiles in regions where during device operation electric field strength is high and dielectric breakdown could damage the device, while also allowing metal tiles to exist elsewhere in order to provide enough overall metal density to satisfy minimum metal-density design rules for device/chip fabrication.

These example embodiments for optimal layout of tiling exclusion zones are particularly beneficial for high-voltage capacitive devices and high-voltage conductors (e.g. traces) anywhere throughout a device's metal layers.

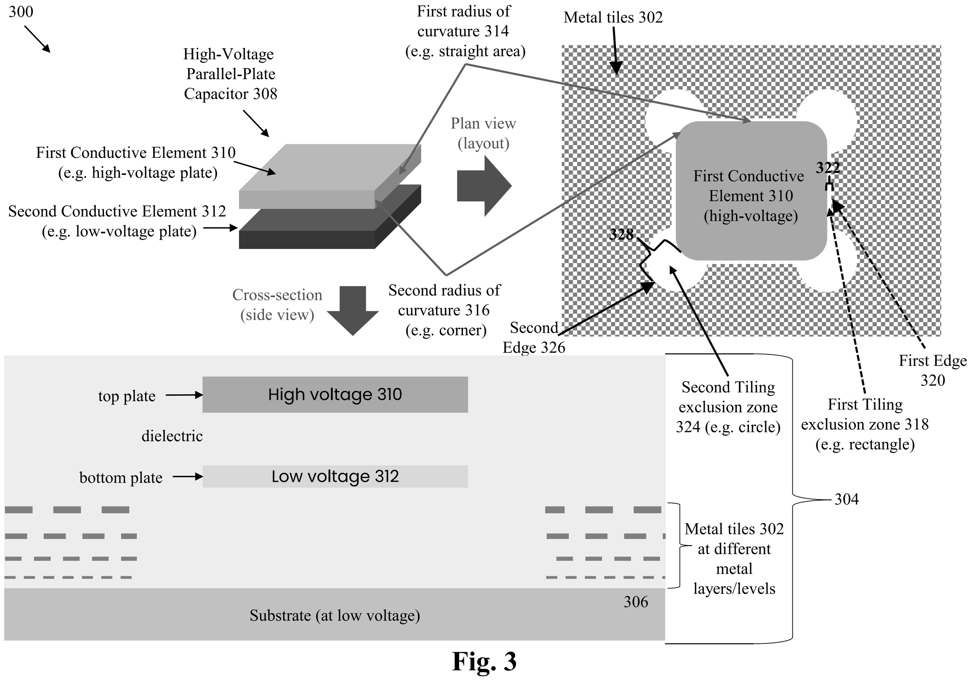

Figure 3 represents a third example 300 of metal tiles 302 in a device 304. The device 304 includes a substrate 306.

The third example 300 includes a high-voltage parallel-plate capacitor 308. The capacitor 308 includes a first conductive element 310 (e.g. high-voltage plate) and a second conductive element 312 (e.g. low-voltage plate). The first conductive element 310 has a first radius of curvature 314 (e.g. straight area) and a second radius of curvature 316 (e.g. corner).

Note, a straight line has an infinite radius of curvature (i.e., it is the edge of a circle of infinite radius), while a perfectly sharp (polygonal) corner has a zero radius of curvature. The smaller the radius of curvature, the sharper the corner is, the larger the electric field strength will be, and the larger the tiling-exclusion distance will preferably be.

In the third example 300 the tiling elements are located only beyond a first predetermined distance 322 from the first radius of curvature 314 of the first conductive element 310, and are located only beyond a second predetermined distance 328 from the second radius of curvature 316 of the first conductive element 310.

Since the risk of dielectric breakdown is greater at the second radius of curvature 316 than at the first radius of curvature 314, the second predetermined distance 328 is greater than the first predetermined distance 322. Dielectric breakdown almost always occurs near the corners of the first conductive element 310 (e.g. high-voltage plate), since the electric field is the highest in those regions, thus the corners of the first conductive element 310 (e.g. high-voltage plate) are made rounded to reduce the local electric field somewhat.

A first tiling exclusion zone 318 (e.g. rectangle) is thus formed within the first predetermined distance 322 up to a first edge 320, and a second tiling exclusion zone 324 (e.g. circle) is formed within the second predetermined distance 328 up to a second edge 326.

Thus by varying shapes of the tiling exclusion zones 318, 324 to remove metal tiles 302 where an electric field is highest (where dielectric breakdown is a risk) but allowing more metal tiles 302 elsewhere to meet the minimum metal density design rules, the third example 300 of metal tiles 302 in the device 304 is more robust and less likely to fail within a TDDB specification.

In some example embodiments, the tiling exclusion zones 318, 324 may not be wholly void of metal tiles 302, but just have a lower density of metal tiles 302. In other example embodiments, the tiling exclusion zone 318 may not be wholly void of metal tiles 302, but just have a lower density of metal tiles 302, while the tiling exclusion zone 324 is wholly void of metal tiles 302.

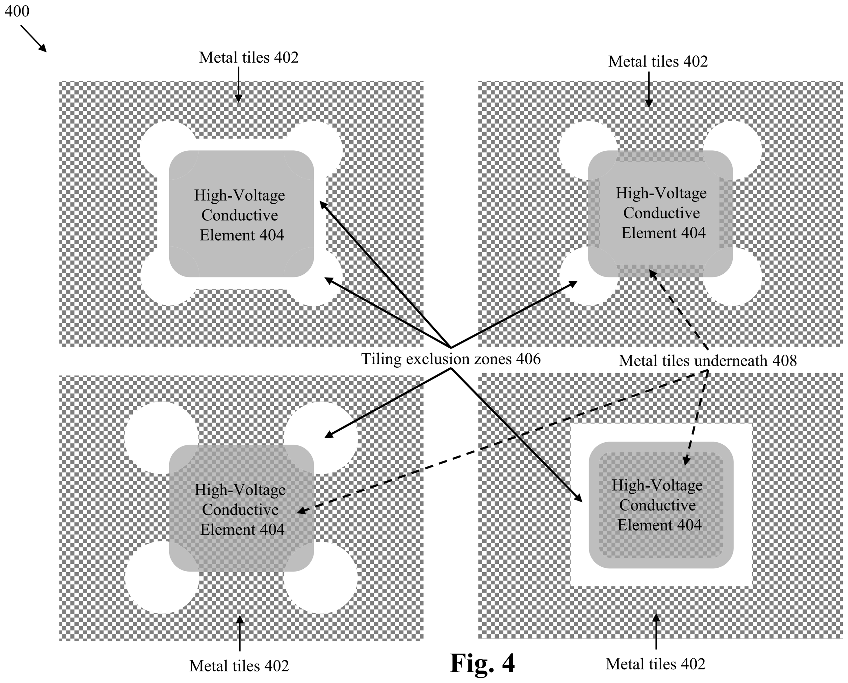

Figure 4 represents additional examples 400 of metal tiles 402 in a device. High-voltage conductive elements 404, variably sized and shaped tiling exclusion zones 406, and metal tiles 402 underneath 408 are shown. In other example embodiments, the metal tiles 402 can be on a layer at or above the high-voltage conductive elements 404.

Different shapes and sizes of tiling exclusion zones 406 are used to achieve an optimum balance between removing metal tiles 402 to enhance breakdown voltage and/or TDDB lifetime, verses providing enough metal tiles 402 to satisfy minimum metal-density rules.

As shown, the tiling exclusion zones 406 can include regions underneath/above 408 where metal tiles 402 are permitted, to further help increase the metal density, as necessary.

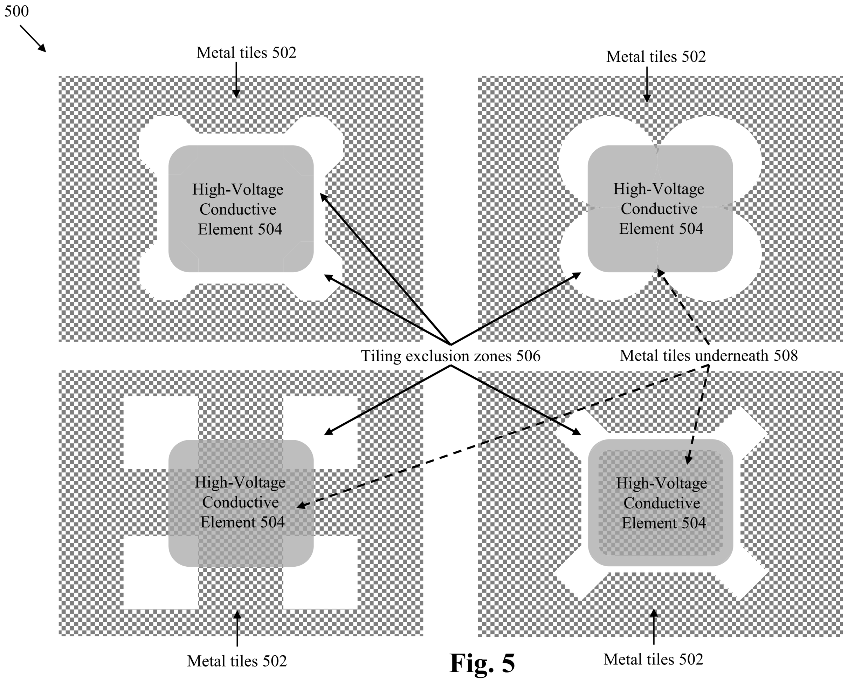

Figure 5 represents further examples 500 of metal tiles 502 in a device. High-voltage conductive elements 504, variably sized and shaped tiling exclusion zones 506, and metal tiles 502 underneath/above 508 are shown.

In some example embodiments, octagonal instead of circular tiling exclusion zones 506 are used if curved edges are not allowed in the fabrication process. Tiling exclusion zones 506 centered on corners of the high-voltage conductive elements 504 could be separate or merged with each other. Metal tiles 502 may or may not be allowed in the central region of the high-voltage conductive elements 504.

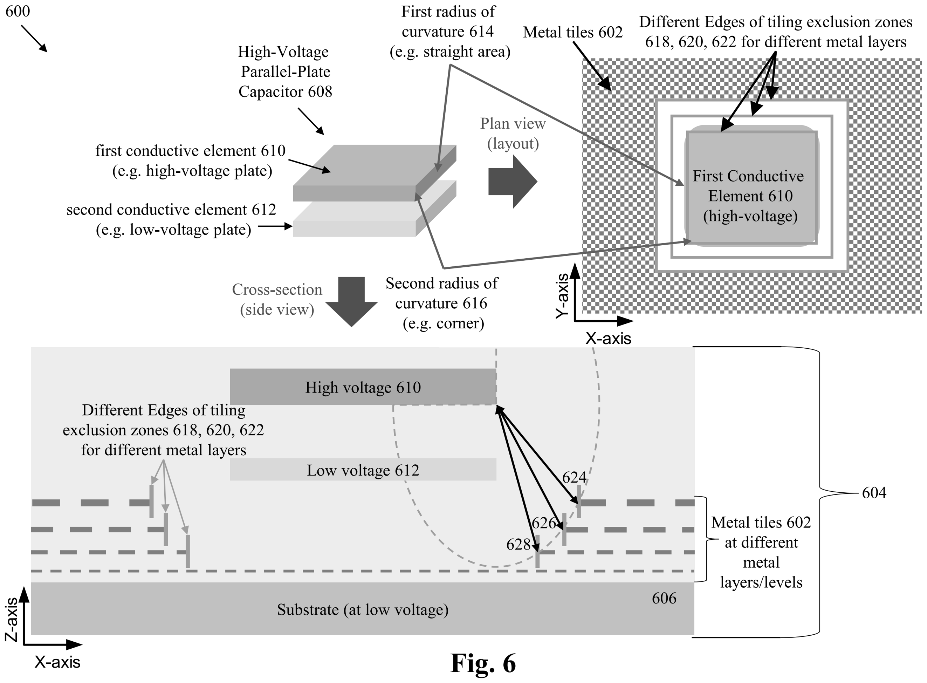

Figure 6 represents an example 600 of tiered sets of metal tiles 602 in a device 604. The device 604 includes a substrate 606.

The example 600 includes a high-voltage parallel-plate capacitor 608. The capacitor 608 includes a first conductive element 610 (e.g. high-voltage plate) and a second conductive element 612 (e.g. low-voltage plate). The first conductive element 610 has a first radius of curvature 614 (e.g. straight area) and a second radius of curvature 616 (e.g. corner).

In the third example 600 a set of tiered tiling exclusion zones 618, 620, 622 are shown at a corresponding set of predetermined distances 624, 626, 628 from the first conductive element 610 (e.g. high-voltage plate).

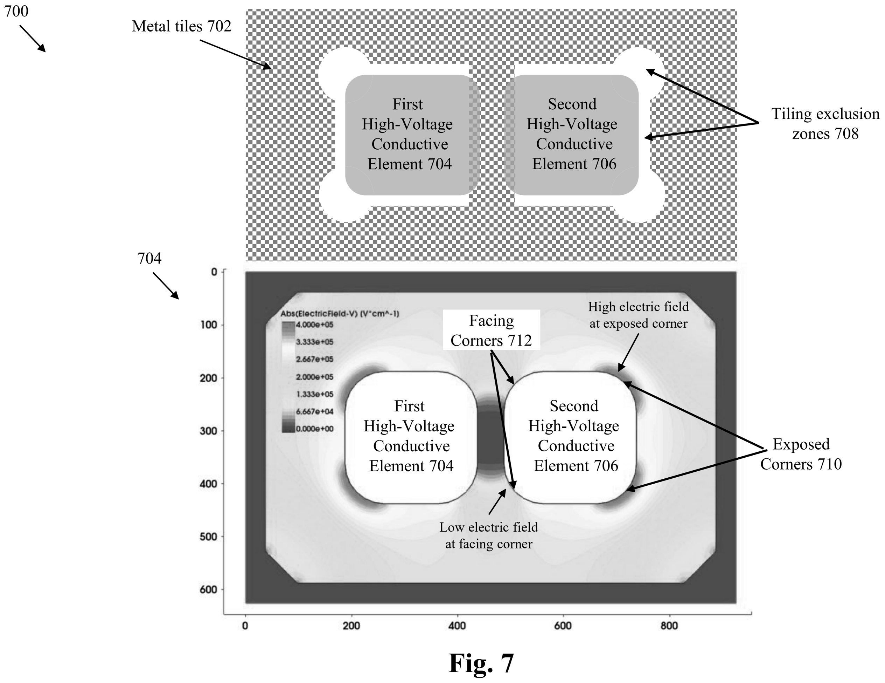

Figure 7 represents a fourth example 700 of metal tiles 702 in a device. A first high-voltage conductive element 704, a second high-voltage conductive element 706, and variably sized and shaped tiling exclusion zones 708 are shown.

A TCAD simulation 704 demonstrates that an electric field magnitude is highest at exposed corners 710 of the first and second high-voltage conductive elements 704, 706. Thus more metal tiles 702 are preferably removed from near the exposed corners 710 as shown. However, the electric field magnitude is lower at facing corners 712 of the first and second high-voltage conductive elements 704, 706. Thus more metal tiles 702 can be kept near the facing corners 712 as shown.

This TCAD simulation 704 assumes that the first and second high-voltage conductive elements 704, 706 are at substantially a same high-voltage potential. So again, the tiling exclusion zones 708 are variably shaped such that there are fewer or no metal tiles 702 in regions where there is a high risk of dielectric breakdown, while metal tiles 702 are permitted elsewhere to satisfy minimum metal-density rules.

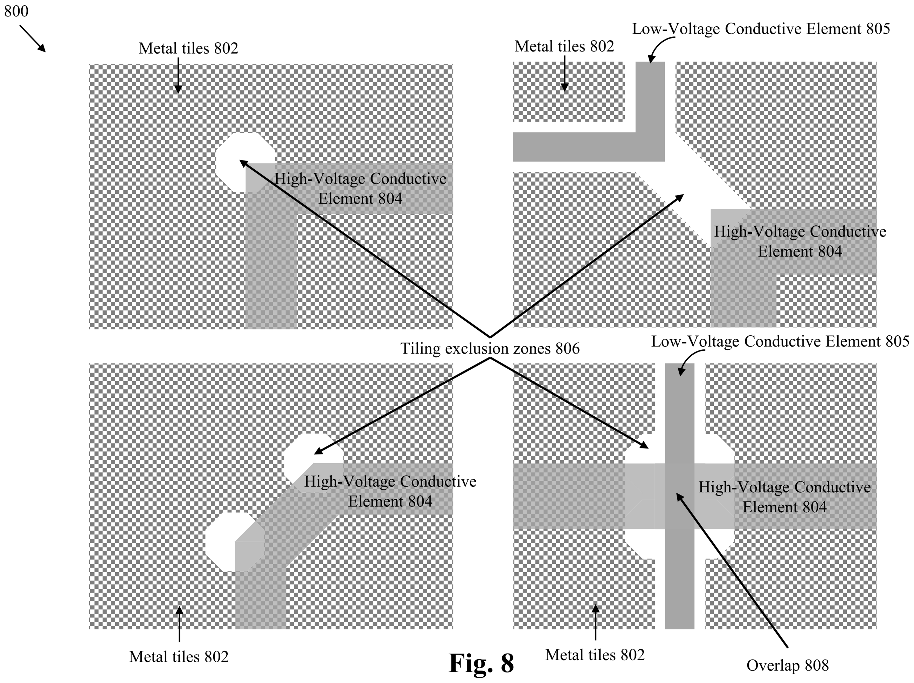

Figure 8 represents additional examples 800 of metal tiles 802 in a device. High-voltage conductive elements 804, low-voltage conductive elements 805, variably sized and shaped tiling exclusion zones 806, and crossing/overlap areas 808 are shown.

The conductive elements 804, 805 can be any conductor (e.g., power routing at a high metal level) that is at danger of causing breakdown with any other conductive element (not shown) or to each other. Any portion of a device having large differences in electrostatic potential can include variably sized and shaped tiling exclusion zones 806 to help prevent dielectric stepping-stone breakdowns.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A device, comprising:
a conductive element having a first radius of curvature and a second radius of curvature;
a set of tiling elements;
wherein the tiling elements are located within a predetermined distance from the first radius of curvature of the conductive element;
wherein the tiling elements are located beyond the predetermined distance from the second radius of curvature of the conductive element; and
wherein the first radius of curvature is different from the second radius of curvature.

2. The device of claim 1:
wherein the first radius of curvature is greater than the second radius of curvature.

3. The device of claim 2:
wherein the first radius of curvature substantially defines a straight line; and
wherein the second radius of curvature substantially defines a corner.

4. The device of any preceding claim:
wherein the second radius of curvature results in a greater electromagnetic field strength than the first radius of curvature when the conductive element is at an electrostatic potential substantially different to that of its surroundings.

5. The device of any preceding claim:
wherein the first radius of curvature is a first non-zero radius of curvature and the second radius of curvature is a second non-zero radius of curvature.

6. The device of any preceding claim:
wherein the predetermined distance is configured to define a tiling exclusion zone.

7. The device of any preceding claim:
wherein the predetermined distance is a first predetermined distance;
wherein the tiling elements are located only beyond the first predetermined distance from the first radius of curvature of the conductive element; and
wherein the tiling elements are located only beyond a second predetermined distance from the second radius of curvature of the conductive element.

8. The device of claim 7:
wherein the second predetermined distance is greater than the first predetermined distance.

9. The device of claim 7 or 8:
wherein a first tiling exclusion zone is formed within the first predetermined distance; and
wherein a second tiling exclusion zone is formed within the second predetermined distance.

10. The device of any preceding claim:
wherein the tiling elements are electrically isolated from the conductive element.

11. The device of any preceding claim:
wherein a size and relative separation of the set of tiling elements is determined by a semiconductor fabrication design rule specifying a minimum metal density.

12. The device of any preceding claim:
wherein a subset of the tiling elements are located underneath the conductive element.

13. The device of any preceding claim:
wherein a subset of the tiling elements are located above the conductive element.

14. The device of any preceding claim:
wherein the conductive element is a capacitor plate or a circuit trace.

15. The device of any preceding claim:
wherein the tiling elements are arranged to increase a dielectric-breakdown voltage of the conductive element.
